# EUROPEAN PATENT APPLICATION

(11) **EP 4 318 015 A1**
(43) Date of publication of application: **07.02.2024**
(21) Application number: 22188003.2
(22) Date of filing: 01.08.2022
(51) Int. Cl.: G01R 33/56, G06N 3/02, G06T 5/00

(54) **MRI DENOISING USING SPECIFIED NOISE PROFILES**

(71) Applicant: Koninklijke Philips N.V., 5656 AG Eindhoven (NL)
(72) Inventor: WUELKER, Christian, Eindhoven (NL); NIELSEN, Tim, Eindhoven (NL)
(74) Representative: Philips Intellectual Property & Standards

(57) **Abstract**

Disclosed herein is a medical system (100, 300) comprising a memory (110) storing machine executable instructions (120) and a group of noise filtering neural networks (122) each configured to remove noise of a specified noise profile from an input magnetic resonance image (124, 600). The execution of the machine executable instructions causes a computational system (104) to: receive (200) an input magnetic resonance image; receive (202) image metadata (126) comprising an image noise profile (128) of the input magnetic resonance image; select (204) a chosen noise filtering neural network (130) by matching the image noise profile to the specified noise profile of each of the group of noise filtering neural networks using a predetermined criterion; and receive (206) the noise filtered magnetic resonance image (132, 604) in response to inputting the input magnetic resonance image into the chosen noise filtering neural network.

## Description

### TECHNICAL FIELD OF THE INVENTION

The invention relates to magnetic resonance imaging, in particular to the removal of noise from magnetic resonance images.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially and imaged using MRI. A difficulty with performing magnetic resonance imaging is that often times magnetic resonance images will contain noise.

The article Kim, et. al., "Unsupervised Image Denoising with Frequency Domain Knowledge," arXiv:2111.14362 [eess.IV], https://doi.org/10.48550/arXiv.2111.14362 discloses that supervised learning-based methods yield robust denoising results, yet they are inherently limited by the need for large-scale clean/noisy paired datasets. The use of unsupervised denoisers, on the other hand, necessitates a more detailed understanding of the underlying image statistics. In particular, it is well known that apparent differences between clean and noisy images are most prominent on high-frequency bands, justifying the use of low-pass filters as part of conventional image preprocessing steps. However, most learning-based denoising methods utilize only one-sided information from the spatial domain without considering frequency domain information. To address this limitation, a frequency-sensitive unsupervised denoising method was used. To this end, a generative adversarial network (GAN) is used as a base structure. The use of a spectral discriminator and frequency reconstruction loss to transfer frequency knowledge into the generator is disclosed. Results using natural and synthetic datasets indicate that the disclosed unsupervised learning method augmented with frequency information achieves state-of-the-art denoising performance, suggesting that frequency domain information could be a viable factor in improving the overall performance of unsupervised learning-based methods.

### SUMMARY OF THE INVENTION

The invention provides for a medical system, a method of training a group of noise filtering networks, a computer program, and a method of operating a medical system in the independent claims. Embodiments are given in the dependent claims.

A particular difficulty in denoising magnetic resonance images is that the power distribution or color of the noise can vary depending upon the sampling in k-space as well as the chosen reconstruction algorithm. Embodiments may provide for an improved means of removing noise from magnetic resonance images by providing for a group of noise filtering neural networks that each have a specified noise profile. An input magnetic resonance image and image metadata are received. The image metadata contains an image noise profile of the input image. The image noise profile is compared to the specified noise profile of each of the group of noise filtering neural networks and used to choose a chosen noise filtering neural network to remove noise from the input image.

In one aspect the invention provides for a medical system that comprises a memory that stores machine-executable instructions and a group of noise filtering neural networks. Each of the group of noise filtering neural networks is configured to output a noise filtered magnetic resonance image in response to receiving an input magnetic resonance image. Each of the group of noise filtering neural networks is configured to remove noise of a specified noise profile from the input magnetic resonance image. The medical system further comprises a computational system. Execution of the machine-executable instructions causes the computational system to receive the input magnetic resonance image. Execution of the machine-executable instructions further causes the computational system to receive image metadata comprising an image noise profile of the input magnetic resonance image. Execution of the machine-executable instructions further causes the computational system to select a chosen noise filtering neural network by matching the image noise profile to the specified noise profile of each of the group of noise filtering neural networks using a predetermined criterion. Execution of the machine-executable instructions further causes the computational system to receive the noise filtered magnetic resonance image in response to inputting the input magnetic resonance image into the chosen noise filtering neural network.

The specified noise profile could for example be a noise power distribution or noise coloration. In other examples the specified noise profile may be specified by a k-space sampling pattern. The predetermined criterion may be used to match the image noise profile to the closest or most appropriate specified noise profile. This could be done by comparing the noise power spectrum of the image noise profile to the various specified noise profiles of each of the group of noise filtering neural networks to find the best match. In other examples the image noise profile could be specified by the k-space sampling pattern in which case the k-space sampling pattern of the group of noise filtering neural networks that is closest could be selected. In other cases, the image noise profile specifies a particular k-space sampling pattern and this sampling pattern exists or is custom made for the group of noise filtering neural networks and an appropriate noise filter is able to be provided.

The different architectures of neural networks which could be used for the group of noise filtering neural networks includes a pulse-coupled neural network, a convolutional neural network, a wavelet neural network, a convolutional neural network-based auto-encoder architecture such as the RED-NET, a UNET, or a ResNet neural network.

These various neural network architectures may be trained by using training images that have the chosen specified noise profile for each of a group of trained images that are provided with both noise and without noise for supervised learning.

In another embodiment each of the group of noise filtering neural networks has a specified k-space sampling pattern and a specified reconstruction algorithm. The image metadata further comprises a k-space sampling pattern identifier and a reconstruction algorithm identifier. The selection of the chosen noise filter is at least partially performed by matching the k-space sampling pattern identifier and the reconstruction algorithm identifier to the specified k-space sampling pattern and the specified reconstruction algorithm of each of the group of noise filtering neural networks. In some examples this could be an exact match or there could be a weighting function that provides the closest to the selected as the predetermined criterion. This embodiment may be beneficial because it may provide for an extremely accurate means of denoising for a particular k-space sampling pattern and specified reconstruction algorithm.

In another embodiment execution of the machine-executable instructions further causes the computational system to receive measured k-space data. The measured k-space data has a predetermined k-space sampling pattern. This predetermined k-space sampling pattern may for example be associated with the k-space sampling pattern identifier in the image data or metadata. The machine-executable instructions further cause the computational system to reconstruct the input magnetic resonance image from the measured k-space data using a chosen magnetic resonance image reconstruction algorithm. The chosen magnetic resonance image reconstruction algorithm may be associated with the reconstruction algorithm identifier. A further step by the computational system may be to assign the k-space sampling pattern identifier using the predetermined k-space sampling pattern and to assign the reconstruction algorithm identifier using the chosen magnetic resonance imaging reconstruction algorithm.

In another embodiment the medical system further comprises a magnetic resonance imaging system. The memory further comprises pulse sequence commands configured to control the magnetic resonance imaging system to acquire the measured k-space sampling data. Execution of the machine-executable instructions further causes the computational system to control the magnetic resonance imaging system to acquire the measured k-space data.

In another embodiment execution of the machine-executable instructions further causes the computational system to reconstruct noise k-space data by filling the predetermined k-space sampling pattern with Gaussian noise. Normally the k-space data is filled with the data acquired by the magnetic resonance imaging system. In this case the various sampling locations are simply filled with Gaussian noise. Execution of the machine-executable instructions further causes the computational system to reconstruct a noise image by applying the chosen magnetic resonance image reconstruction algorithm to the noise k-space data. Execution of the machine-executable instructions further causes the computational system to calculate the image noise profile from the noise image. Execution of the machine-executable instructions further causes the computational system to construct the image metadata using the image noise profile. This embodiment provides an alternative to strictly specifying a particular k-space sampling pattern and using the specific pattern to recall or select the chosen noise filtering neural network from the group of noise filtering neural networks. In this embodiment the k-space data is filled with noise and then the image is reconstructed using the chosen magnetic resonance reconstruction algorithm. The result is that an image is reconstructed that has a noise power spectrum or noise profile which is caused by the particular k-space sampling pattern and the reconstruction algorithm.

In another embodiment execution of the machine-executable instructions further causes the computational system to identify a region of constant image intensity within the input magnetic resonance image and then to calculate the image noise profile from the region of constant image intensity. In some instances, it may not be feasible to go through and reconstruct a complete noise power spectrum by artificially filling the k-space data and using the particular reconstruction algorithm. In this case, the image noise profile is essentially measured from this region of constant image intensity. This embodiment may be particularly beneficial when the k-space sampling pattern of the image is unknown. It may also enable the calculation of an image noise profile more rapidly.

In another embodiment execution of the machine-executable instructions further causes the computational system to calculate a group of trial images by inputting the magnetic resonance image into each of a group of noise filtering neural networks. Execution of the machine-executable instructions further causes the computational system to calculate an image metric for each of the group of trial images. Execution of the machine-executable instructions further causes the computational system to select the image noise profile by applying a predetermined selection criterion to the image metric for each of the group of trial images. This embodiment has the benefit that the chosen noise filtering neural network can be chosen using a means that does not require an exact knowledge of the image noise profile. Also, the selection of the chosen noise filtering neural network also causes the noise filtered magnetic resonance image to be calculated at the same time. When the image is put into the noise filtering neural network that is ultimately selected as the chosen noise filtering neural network the resulting image can then just be used as the noise filter magnetic resonance image.

In another embodiment the image metric is an image sharpness.

In another embodiment the image metric is a signal-to-noise ratio.

In another embodiment the image metric is a contrast-to-noise ratio.

In another embodiment the image metric is a spatial resolution.

In other embodiments a combination of the above-mentioned image metrics may be combined or used together.

Execution of the machine-executable instructions further causes the computational system to receive a training k-space sampling pattern. Execution of the machine-executable instructions further causes the computational system to receive a training magnetic resonance imaging reconstruction algorithm. Execution of the machine-executable instructions further causes the computational system to determine a training noise profile using the k-space sampling pattern and the training magnetic resonance imaging reconstruction algorithm. Execution of the machine-executable instructions further causes the computational system to receive a group of training images.

Execution of the machine-executable instructions further causes the computational system to repeatedly select a training image from the group of training images, construct a ground truth image from the training image, construct a trial image with the training noise profile from the training image and then to train the selected noise filtering neural network using the trial image and the ground truth image. The selected noise filtering neural network is a member of the group of noise filtering neural networks. The selected noise filtering neural network has the specified noise profile to set the training noise profile. This embodiment may be beneficial because it may for example provide for a means of training for a particular noise filtering neural network with a specified noise profile on demand or as it is needed. For example, if a particular noise profile were not available previously, then the needed noise filtering neural network could be trained on demand. This could then be stored for later use.

In another embodiment execution of the machine-executable instructions further causes the computational system to construct resampled k-space data from the training image by applying a non-equally spaced FFT to resample the training image to the training k-space sampling pattern. The ground truth image is constructed by applying an inverse of the non-equally spaced FFT to the resampled k-space data. Execution of the machine-executable instructions further causes the computational system to construct trial k-space data by adding Gaussian noise to the resampled k-space data. The trial image is constructed by applying the inverse of the non-equally spaced FFT to the trial k-space data. This embodiment may be beneficial because it enables the construction of training data which will have the noise profile which is associated with a particular k-space sampling pattern.

In another embodiment the ground truth image is the training image and/or the training image constructed by adding noise with the training noise profile to the training image. This embodiment may be beneficial because it may provide for a faster and computationally less intensive means of training the group of noise filtering neural networks.

In another embodiment the selected noise filtering neural network is trained in a residual learning mode.

In another aspect the invention provides for a method of training a group of noise filtering neural networks. The method comprises performing the following steps repeatedly for each member of the group of noise filtering neural networks. The steps include receiving a training k-space sampling pattern, and receiving a training magnetic resonance imaging reconstruction algorithm. The steps further comprise determining a training noise profile using the k-space sampling pattern and the training magnetic resonance imaging reconstruction algorithm. The steps further comprise repeatedly receiving a group of training images. The method further comprises repeatedly selecting a training image from the group of training images. The method further comprises repeatedly constructing a ground truth image from the training image.

The method further comprises constructing a trial image with the training noise profile from the training image. This for example could be by adding noise directly to the image or by a process of resampling two particular k-space sampling patterns and then transforming the image back into image space after noise has been added in k-space. The method further comprises repeatedly training a selected noise filtering neural network using the trial image and the ground truth image. The selected noise filtering neural network is a member of the group of noise filtering neural networks. The selected noise filtering neural network has the specified noise profile set to the training noise profile. The method further comprises repeatedly adding the selected noise filtering neural network to the group of noise filtering neural networks.

In another aspect the invention provides for a computer program comprising machine-executable instructions for execution by a computational system. The computer program further comprises a group of noise filtering neural networks. Each of the group of noise filtering neural networks is configured to output a noise filtered magnetic resonance image in response to receiving an input magnetic resonance image. Each of the group of noise filtering neural networks is configured to remove noise of a specified noise profile from the input magnetic resonance image. Execution of the machine-executable instructions causes the computational system to receive the input magnetic resonance image. Execution of the machine-executable instructions further causes the computational system to receive image metadata comprising an image noise profile of the input magnetic resonance image.

Execution of the machine-executable instructions further causes the computational system to select a chosen noise filtering neural network by matching the image noise profile to the specified noise profile of each of the group of noise filtering neural networks using a predetermined criterion. Execution of the machine-executable instructions further causes the computational system to receive the noise filtered magnetic resonance image in response to inputting the input magnetic resonance image into the chosen noise filtering neural network.

In another aspect the invention provides for a method of medical imaging. The method comprises receiving an input magnetic resonance image. The method further comprises receiving image metadata comprising an image noise profile of the input magnetic resonance image. The method further comprises selecting a chosen noise filtering neural network by matching the image noise profile to the specified noise profile for each of a group of noise filtering neural networks using a predetermined criterion. Each of the group of noise filtering neural networks is configured to output a noise filtered magnetic resonance image in response to receiving the input magnetic resonance image. Each of the group of noise filtering neural networks is configured to remove noise of a specified noise profile from the input magnetic resonance image. The method further comprises receiving the noise filtered magnetic resonance image in response to inputting the input magnetic resonance image into the chosen noise filtering neural network.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1;
Fig. 3 illustrates a further example of a medical system;
Fig. 4 shows a flow chart which illustrates a method of using the medical system of Fig. 1;
Fig. 5 illustrates a method of training a group of noise filtering neural networks;
Fig. 6 compares an unfiltered magnetic resonance image with two different images denoised with different neural networks; and
Fig. 7 illustrates the steps that may be performed in training a selected noise filtering neural network.

### DETAILED DESCRIPTION OF EMBODIMENTS

Like numbered elements in these figures are either equivalent elements or perform the same function. Elements which have been discussed previously will not necessarily be discussed in later figures if the function is equivalent.

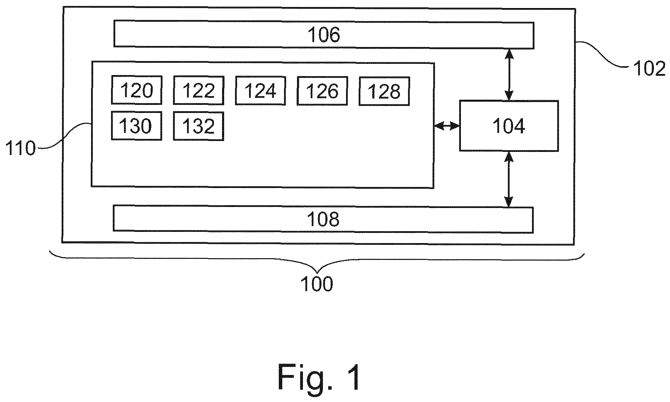

Fig. 1 illustrates an example of a medical system 100. The medical system 100 is shown as comprising a computer 102. The computer 102 is intended to represent one or more computers at one or more locations. Within the computer 102 there is a computational system 104 that is intended to represent one or more computational systems or computing cores at one or more locations. For example, it could be a distributed or cloud-based system. The computational system 104 is shown as being in contact with an optional hardware interface 106 and an optional user interface 108. The hardware interface 106 may be used for controlling and operating other components of the medical system 100 such as the magnetic resonance imaging system if it is present. The user interface 108 may enable an operator or user to operate and control the medical system 100.

The computational system 104 is further shown as being in communication with a memory 110. The memory 110 is intended to represent different types of memory or computer memory that are accessible to the computational system 104. The memory 110 may for example be a non-transitory storage medium.

The memory 110 is shown as containing machine-executable instructions 120. The machine-executable instructions 120 enable the computational system 104 to perform various mathematical, data processing, and image processing tasks. The machine-executable instructions 120 may also further enable the computational system 104 to do such things as control other components such as a magnetic resonance imaging system. The memory 110 is further shown as containing a group of noise filtering neural networks. The noise filtering neural networks comprises individual noise filtering neural networks that is configured to remove noise from an image with a specified noise profile. This for example may be a specific noise power spectrum or noise color. The memory 110 is further shown as containing an input magnetic resonance image 124. This is a magnetic resonance image 124.

The memory 110 is further shown as containing image metadata 126 that is descriptive of the input magnetic resonance image 124. This may contain such information as an image noise profile 128, which is also shown as being stored in the memory 110, as well as a k-space sampling pattern or other information about the input magnetic resonance image 124. The memory 110 is further shown as containing a chosen noise filtering neural network 130 that was selected from the group of noise filtering neural networks 122 using the image metadata 126. For example, the image noise profile 128 may be used to select the chosen noise filtering neural network 130 from the group of noise filtering neural networks 122 using a predetermined criterion. The memory 110 is further shown as containing a noise filtered magnetic resonance image 132 that was constructed by inputting the input magnetic resonance image 124 into the chosen noise filtering neural network 130.

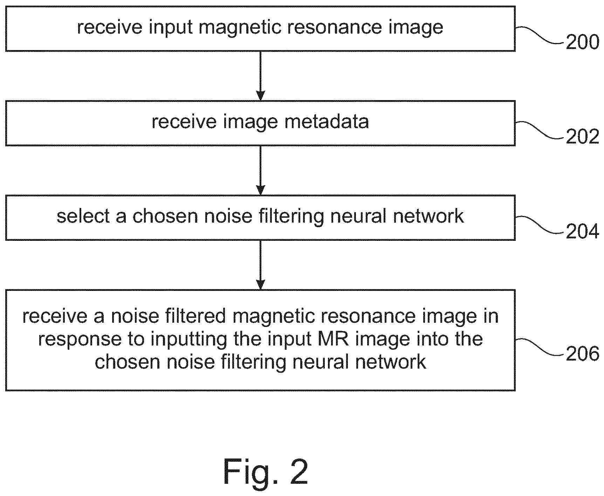

Fig. 2 shows a flowchart which illustrates a method of operating the medical system 100 of Fig. 1. In step 200 the input magnetic resonance image 124 is received. Next, in step 202, the image metadata 126 comprising the image noise profile 128 is received. Next, in step 204, the chosen noise filtering neural network 130 is selected from the group of noise filtering neural networks 122 by matching the image noise profile 128 to a specified noise profile of each of the group of noise filtering neural networks using a predetermined criterion. Finally, in step 206, the noise filtered magnetic resonance image 132 is received in response to inputting the input magnetic resonance image 124 into the chosen noise filtering neural network 130.

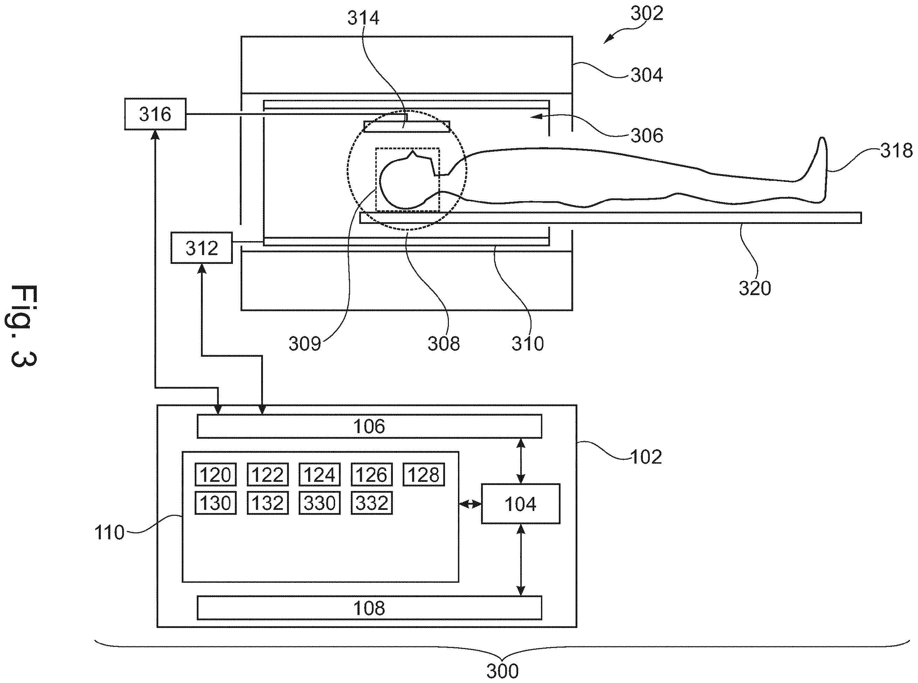

Fig. 3 shows a further example of the medical system 300. The medical system 300 is similar to that as is displayed in Fig. 1 except it additionally comprises a magnetic resonance imaging system 302 that is controlled by the computational system 104.

The magnetic resonance imaging system 302 comprises a magnet 304. The magnet 304 is a superconducting cylindrical type magnet with a bore 306 through it. The use of different types of magnets is also possible; for instance, it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data that is acquired typically acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for acquisition of preliminary k-space data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise, the transceiver 316 may also represent a separate transmitter and receivers. The radio-frequency coil 314 may also have multiple receive/transmit elements and the radio frequency transceiver 316 may have multiple receive/transmit channels. The transceiver 316 and the gradient controller 312 are shown as being connected to the hardware interface 106 of the computer system 102.

The memory 110 is further shown as containing pulse sequence commands 330. The memory 110 is further shown as containing measured k-space data 332 that has been acquired by controlling the magnetic resonance imaging system 302 with the pulse sequence commands 330. The measured k-space data 332 may be reconstructed into the input magnetic resonance image 124 and various data about the acquisition may be used to provide the image metadata 126. Further calculations may be used to provide the image noise profile 128. This may be performed by either performing an image analysis, for example, on a region of constant image intensity, or it may be performed as was described above, by using the sampling pattern for the measured k-space data 332 and filling these points in k-space with Gaussian noise and then reconstructing the image using the same reconstruction algorithm as was used for reconstructing the input magnetic resonance image 124.

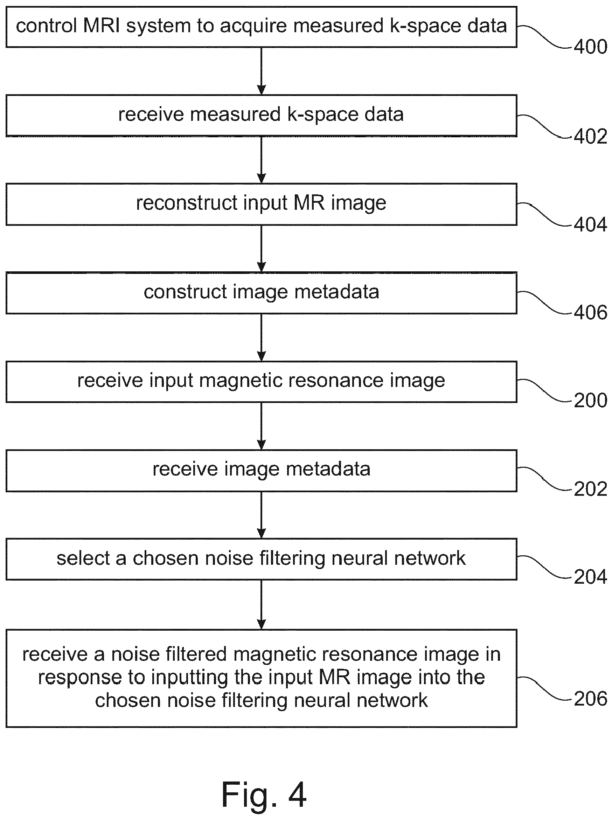

Fig. 4 shows a flowchart which illustrates a method of operating the medical system 300 of Fig. 3. First, in step 400, the magnetic resonance imaging system 302 is controlled with the pulse sequence commands 330 to acquire the measured k-space data 332. In step 402 the measured k-space data is received. This may for example be performed by recalling the measured k-space data 332 from the memory 110 or it may be provided from the acquisition of the measured k-space data 332. Next, in step 404, the input magnetic resonance image 124 is reconstructed from the measured k-space data 332 using a chosen or predetermined magnetic resonance imaging reconstruction algorithm. Next, in step 406, the image metadata is constructed. This may for example, as was mentioned above, be constructed using various image parameters and acquisition details used to reconstruct the input magnetic resonance image 124. After step 406 is performed steps 200, 202, 204, and 206 are performed as was illustrated previously in Fig. 2.

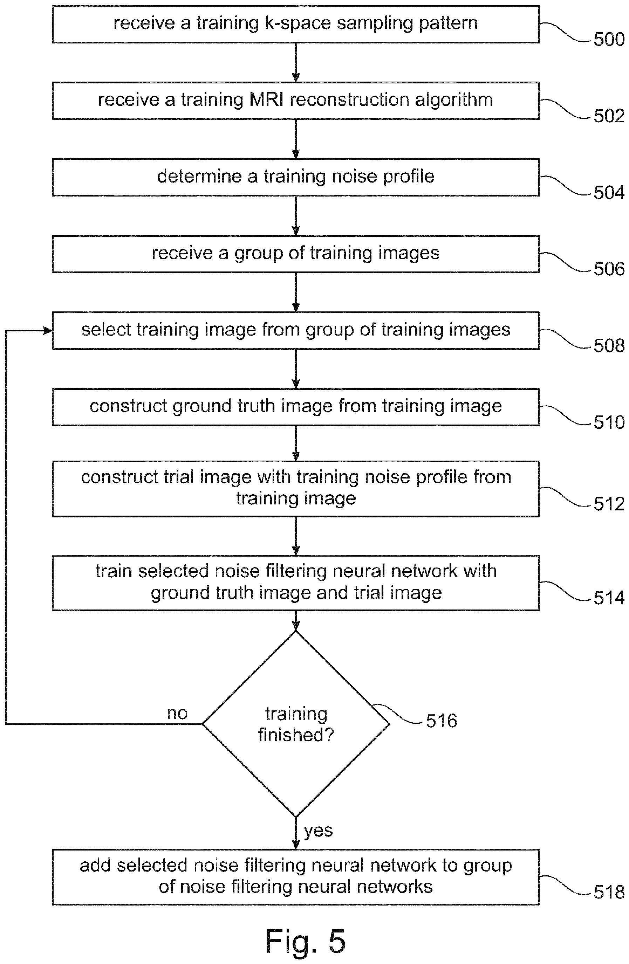

Fig. 5 illustrates a method of training a group of noise filtering neural networks. The flowchart in Fig. 5 illustrates a method of training one of the group of noise filtering neural networks. To provide for a group the method illustrated in Fig. 5 would be repeated multiple times. First, in step 500, a training k-space sampling pattern is received. This for example may be a k-space sampling pattern that is used for a particular magnetic resonance imaging protocol or acquisition method. Next, in step 502, a training magnetic resonance imaging reconstruction algorithm 502 is received. The training magnetic resonance imaging reconstruction algorithm may for example be a reconstruction algorithm that is used in a clinical setting for a particular magnetic resonance imaging protocol. The training k-space sampling pattern and the training MRI reconstruction algorithm could for example be one of a library of k-space sampling patterns and MRI reconstruction algorithms that would be built up for making the group of noise filtering neural networks. Next, in step 504, a training noise profile is determined using the training k-space sampling pattern and the training magnetic resonance imaging reconstruction algorithm. As was described previously noise could be added to the locations of the k-space sampling pattern and then this resulting k-space data with noise added is then reconstructed and turned into an image using the training magnetic resonance imaging reconstruction algorithm. This then results in an image which is filled with the particular training noise profile. Basic image measurements can be performed on this resulting image to determine the training noise profile.

Next, in step 506, a group of training images is received. This could for example be medical images but it could also be normal optical images. A variety of different images may be used for training a particular noise filtering neural network. The method then proceeds to steps 508, 510, 512, 514 and 516. This is shown as a sequential loop, however, when training neural networks often times the training data is collected and it is trained using a vector process where the training is performed simultaneously or in a parallel fashion. It is understood herein that the sequential method illustrated in Fig. 5 may also be performed in a parallel fashion. After step 506 is performed, the method then proceeds to step 508 and a training image from the group of training images is selected.

Next, in step 510, a ground truth image is constructed from the training image. This could for example be taking the training image, resampling it to the training k-space sampling pattern and then retransforming it back into image space. This would then have undersampling artifacts and other image imperfections caused by the particular k-space sampling pattern and reconstruction algorithm. Next, in step 512, a trial image with the training noise profile is constructed from the training image. For example, the training image could be resampled into the training k-space sampling pattern and then have some Gaussian noise added at various locations to simulate the noise and then be reconstructed back into image space. The steps 510 and 512 result in a ground truth image that does not have noise in the image but may have some artifacts due to the particular training k-space sampling pattern and the trial image which has both the noise of the training noise profile and artifacts from the training k-space sampling pattern. Then, in step 514, the selected noise filtering neural network is trained with the ground truth image and the trial image developed in steps 510 and 512 respectively. The method then proceeds to step 516. In this question box it is asked, 'is the training finished?' if the answer is no then the method returns back to step 508 and another training image is selected and the process is repeated. If the answer is yes then the training is finished and in step 518 the selected noise filtering neural network is added to the group of noise filtering neural networks.

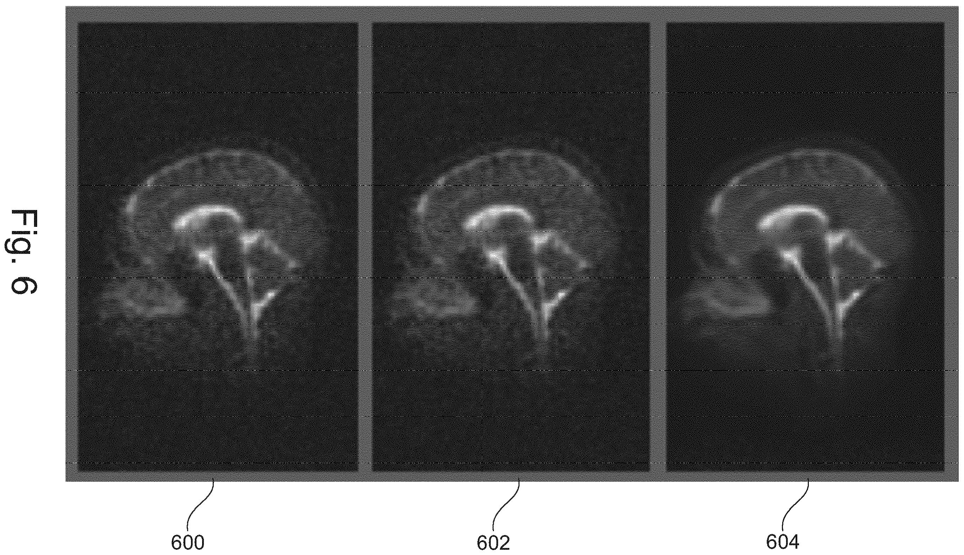

Image quality is an important aspect of MRI as it has a substantial impact on diagnostic confidence and reading time of a radiologist. Higher image quality, characterized e.g. by a high signal-to-noise ratio (SNR), can be achieved by multiple acquisitions (NSA) at the same locations in k-space and subsequent averaging. However, this procedure substantially increases cost and processing time and is therefore not feasible in many cases. As an alternative, denoising methods can be used that remove noise from a low-quality image and recover a higher-SNR image. In particular, AI-based deep learning methods that remove noise from MR images have shown to deliver superior image quality as compared to classical denoising methods. However, it has become apparent that a denoising neural network that was trained for a particular noise power spectrum (NPS) will poorly (not at all) generalize to other types of colored noise. Therefore, examples may provide for training different networks (122 group of noise filtering neural networks) for different types of MR acquisition schemes. These are combined into an AI denoising framework with NPS awareness (using the image noise profile 128 to select the chosen noise filtering neural network 130). Described below (in Fig. 6) is an example that uses a radial k-space sampling trajectory that shows a denoising network trained with uncorrelated Gaussian noise will not denoise the image, while a dedicatedly trained network (the chosen noise filtering neural network 130) delivers satisfactory denoising performance.

Different neural networks are trained using different NPSs used for training data generation. The training data may be real MR images or natural images or other type of imagery. Data augmentation may be applied during training to improve generalization strength of a single network to different trajectories of the same type. During inference, the denoising network is chosen in accordance with the NPS that is known a priori.

Fig. 6 shows three different magnetic resonance images 600, 602, and 604. Image 600 on the left is a low signal-to-noise sodium magnetic resonance image without any denoising. Image 602 is image 600 that has been denoised with a neural network that is trained on uncorrelated Gaussian white noise. The image on the right, image 604, is image 600 that has been denoised with a neural network that has been trained for a particular noise power spectrum; in this case the noise power spectrum that results from the particular k-space sampling pattern and the reconstruction algorithm. It can be seen that the denoising of image 604 is very superior to the denoising of image 602. Fig. 6 compares the denoising performance of two different denoising neural networks in a low- SNR example with a radial trajectory. It can be seen that the denoising network dedicatedly trained for the particular NPS delivers satisfactory denoising performance, while a generic denoising network trained with uncorrelated Gaussian white noise does not denoise the image. We obtained analogous results with a spiral trajectory.

Examples may provide for generating training data with specific noise power spectrums (NPS) (noise profiles) and respectively train dedicated networks for these spectra. When the above described approach is used in practice to denoise an MR image, the NPS of the input image is known a priori, so the right network can be selected from a set of pre-trained networks based on this criterion (as well as others). As described, neural networks will poorly generalize to NPS not used in training. On the other hand, training multiple NPS into a single network is also suboptimal due to network capacity limitations. Also note that the storage requirements for a pre-trained AI denoiser are not critical at all (only about several MB per network).

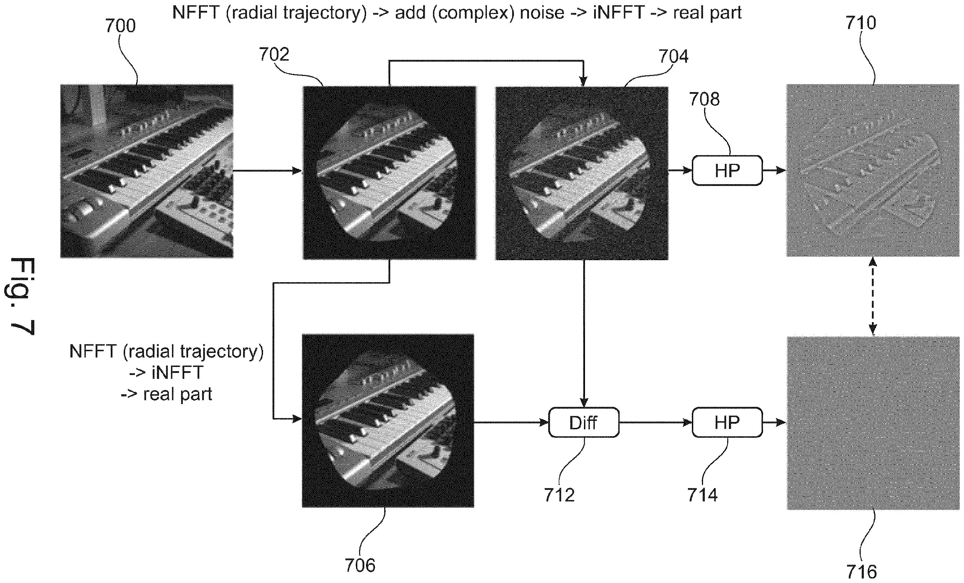

One way to generate training data with a specific NPS for training an AI denoising network for MRI is depicted in Fig. 7 below. In this example, natural images are used as the basis, but MRI images could also be used. The idea in this example is that we choose a certain sampling pattern (in this case, a radial trajectory) with corresponding weights, and a non-equispaced FFT (NFFT) is used to sample the image in k-space on this trajectory. To each point in k-space, we then add complex noise, and use an inverse NFFT to convert these noisy data back to image space and take the real part. To derive training target images, we use an image that was converted to k-space and back without adding noise.

This is done to train the network to remove only noise, not undersampling artifacts, etc. We generally advise to train AI denoising networks in residual learning mode, which means that the network will output an estimate of the noise in the input image. The training target will therefore be the difference between the noisy and the noise-free image, as shown in Fig. 1. All features of an AI denoising framework, such as a frequency split of masking of the input images (cf. Fig. 7 below), are fully compatible with the approach described here. Given complex training data, it is also possible to train a complex denoising network, of course. The sampling pattern can be changed in all different ways to create training data with different NPS (e.g., switching to a spiral or propeller trajectory instead of a radial one).

Fig. 7 illustrates the steps that may be performed in training a selected noise filtering neural network. Fig. 7 provides an example for generating training data with a specific NPS using natural images and NFFTs, given a radial sampling trajectory. The steps illustrated in Fig. 7 are similar to those performed and illustrated in the flowchart in Fig. 5. In the left of Fig. 7, 700 represents a training image 700. The image adjacent to this, image 702, is the same image with an image mask applied. It may be beneficial to apply a mask such as is illustrated image 702 because many medical images, particularly magnetic resonance images, have dark regions surrounding the anatomical data in the magnetic resonance image. Image 704 represents a trial image 704 that would be input into the neural network during training. Image 704 was constructed by resampling image 702 using an NFFT with a radial trajectory. Once it was resampled into k-space complex noise was then added to the k-space data and an inverse NFFT was applied to provide the image 704. In 704 only the real portion of the image is displayed.

Image 706 represents a ground truth image in a non-residual mode. For example, it would be image 704 with the noise removed. Image 706 may be constructed by resampling image 702 using an NFFT for the radial trajectory into k-space. This data is then transformed again using an inverse NFFT back into image space. The image 706 is only the real portion of the image that is displayed.

Returning to image 704, block 708 represents a high-pass filter. The image 710 is a high-pass filtered version of image 704. A large amount of noise as well as some spatial data is displayed. Block 702 below represents a difference between images 704 and 706. The output of this block represents just the noise of the image. The difference, 702, is displayed in image 716. In this example a high-pass filter 714 has been applied before displaying the image. The high-pass filter 714 may not be necessary. Image 716 represents a ground truth image for training the neural network in a residual mode. The training data for training the neural network would either be 704 being input into the neural network with 706 being the ground truth data or image 716 depending upon how one wanted to train the neural network.

This is just one way to generate training data with a certain NPS. Several alternatives to the method illustrated in Fig. 7 are described briefly in the following:
1. Instead of explicitly simulating independent noise in k-space and converting this into an image by gridding, noise with the desired NPS could be simulated directly in image space and added to the noise free image for training the network. This has the advantage that it is much faster. But a disadvantage is that the noise generation in the image domain is only an approximation to the true noise distribution.
2. In the previous description also the noise free image was converted to k-space and back, i.e. the training target image will have ringing and sub-sampling artifacts associated with the acquisition pattern. If instead the original source image is used directly as training target, the network would also learn to remove these residual artifacts next to removing the noise. The advantage would be an even better image quality. The disadvantage would be less control on the image appearance because the other artifacts could also be removed by dedicated methods and then the strength of noise and artifact removal could be controlled independently.
3. The idea of also removing residual artifacts from the reconstruction can be expanded further by making the simulation of the input and target image even more realistic. By e.g. simulating multi-channel data or by using a particular implementation of a reconstruction algorithm, e.g. the actual C-SENSE algorithm of the product software, in the generation of the training data. This would prolong the generation of the training data but would improve performance.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: computer
- 104: computational system
- 106: hardware interface
- 108: user interface
- 110: memory
- 120: machine executable instructions
- 122: group of noise filtering neural networks
- 124: input magnetic resonance image
- 126: image metadata
- 128: image noise profile
- 130: chosen noise filtering neural network
- 132: noise filtered magnetic resonance image
- 200: receive the input magnetic resonance image
- 202: receive image metadata comprising an image noise profile of the input magnetic resonance image
- 204: select a chosen noise filtering neural network by matching the image noise profile to the specified noise profile of each of the group of noise filtering neural networks using a predetermined criterion
- 206: receive the noise filtered magnetic resonance image in response to inputting the input magnetic resonance image into the chosen noise filtering neural network
- 300: medical system
- 302: magnetic resonance imaging system
- 304: magnet
- 306: bore of magnet
- 308: imaging zone
- 309: field of view
- 310: magnetic field gradient coils
- 312: magnetic field gradient coil power supply
- 314: radio-frequency coil
- 316: transceiver
- 318: subject
- 320: subject support
- 330: pulse sequence commands
- 332: measured k-space data
- 400: control the magnetic resonance imaging system with the pulse sequence commands to acquire the measured k-space data
- 402: receive measured k-space data
- 404: reconstruct the input magnetic resonance image from the measured k-space data using a chosen magnetic resonance imaging reconstruction algorithm
- 500: receiving a training k-space sampling pattern
- 502: receiving a training magnetic resonance imaging reconstruction algorithm
- 504: determine a training noise profile using the k-space sampling pattern and the training magnetic resonance imaging reconstruction algorithm
- 506: receiving a group of training images
- 508: selecting a training image from the group of training images
- 510: constructing a ground truth image from the training image
- 512: constructing a trial image with the training noise profile from the training image
- 514: training a selected noise filtering neural network using the trial image and the ground truth image
- 516: training finished?
- 518: adding the selected noise filtering neural network to the group of noise filtering neural networks
- 600: low-SNR Sodium MR image without denoising
- 602: image 600 denoised with neural network trained to remove Gaussian noise
- 604: image 600 denoise with neural network trained to remove noise with a particular noise power spectrum
- 700: training image
- 702: training image with mask applied
- 704: trial image
- 706: ground truth image (non-residual)
- 708: high pass filter
- 710: filtered image
- 712: image difference
- 714: high pass filter
- 716: ground truth image (residual image)

## Claims

1. A medical system (100, 300) comprising:
- a memory (110) storing machine executable instructions (120) and a group of noise filtering neural networks (122), wherein each of the group of noise filtering neural networks is configured to output a noise filtered magnetic resonance image (132, 604) in response to receiving an input magnetic resonance image (124, 600), wherein each of the group of noise filtering neural networks is configured to remove noise of a specified noise profile from the input magnetic resonance image; and
- a computational system (104), wherein the execution of the machine executable instructions causes the computational system to:
- receive (200) the input magnetic resonance image;
- receive (202) image metadata (126) comprising an image noise profile (128) of the input magnetic resonance image;
- select (204) a chosen noise filtering neural network (130) by matching the image noise profile to the specified noise profile of each of the group of noise filtering neural networks using a predetermined criterion; and
- receive (206) the noise filtered magnetic resonance image in response to inputting the input magnetic resonance image into the chosen noise filtering neural network.

2. The medical system of any one of the preceding claims, wherein each of the group of noise filtering neural networks has a specified k-space sampling pattern and a specified reconstruction algorithm, wherein the image metadata further comprises a k-space sampling pattern identifier and a reconstruction algorithm identifier, wherein the selection of the chosen noise filter is at least partially performed by matching the k-space sampling pattern identifier and the reconstruction algorithm identifier to the specified k-space sampling pattern and the specified reconstruction algorithm of each of the group of noise filtering neural networks.

3. The medical system of claim 1 or 2, wherein execution of the machine executable instructions further causes the computational system to:
- receive (402) measured k-space data (332), wherein the measured k-space data has a predetermined k-space sampling pattern;
- reconstruct (404) the input magnetic resonance image from the measured k-space data using a chosen magnetic resonance imaging reconstruction algorithm.

4. The medical system of claim 3, wherein the medical system further comprises a magnetic resonance imaging system, wherein the memory further comprises pulse sequence commands configured to control the magnetic resonance imaging system to acquire the measured k-space data, wherein execution of the machine executable instructions further causes the computational system to control (400) the magnetic resonance imaging system with the pulse sequence commands to acquire the measured k-space data.

5. The medical system of claim 2 or 3, wherein execution of the machine executable instructions further causes the computational system to:
- construct noise k-space data by filling the predetermined k-space sampling pattern with Gaussian noise;
- reconstruct a noise image by applying the chosen magnetic resonance imaging reconstruction algorithm to the noise k-space data; and
- calculate the image noise profile from the noise image; and
- construct the image metadata using the image noise profile.

6. The medical system of any one of claims 1 through 4, wherein execution of the machine executable instructions further causes the computational system to:
- identify a region of constant image intensity within the input magnetic resonance image; and
- calculate the image noise profile from the region of constant image intensity.

7. The medical system of any one of claims 1 through 4, wherein execution of the machine executable instructions further causes the computational system to:
- calculate a group of trial images by inputting the input magnetic resonance image into each of the group of noise filtering neural networks;
- calculate an image metric for each of the group of trial images; and
- select the image noise profile by applying a predetermined selection criterion to the image metric for each of the group of trial images.

8. The medical system of claim 7, wherein the image metric is any one of the following: image sharpness, signal-to-noise ratio, contrast-to-noise ratio, a spatial resolution, and combinations thereof.

9. The medical system of any one of the preceding claims, wherein execution of the machine executable instructions further causes the computational system to:
- receive (500) a training k-space sampling pattern;
- receive (502) a training magnetic resonance imaging reconstruction algorithm;
- determine (504) a training noise profile using the k-space sampling pattern and the training magnetic resonance imaging reconstruction algorithm;
- receive (506) a group of training images;
wherein execution of the machine executable instructions further causes the computational system to repeatedly:
- select (508) a training image (700) from the group of training images;
- construct (510) a ground truth image (706, 716) from the training image;
- construct (512) a trial image (704) with the training noise profile from the training image; and
- train (514) a selected noise filtering neural network using the trial image and the ground truth image, wherein the selected noise filtering neural network is a member of the group of noise filtering neural networks, wherein the selected noise filter neural network has the specified noise profile set to the training noise profile.

10. The medical system of claim 9, wherein execution of the machine executable instructions further causes the computational system to:
- construct resampled k-space data from the training image by applying a non-equispaced FFT to resample the training image to the training k-space sampling pattern, wherein the ground truth image is constructed by applying an inverse of the non-equispaced FFT to the resampled k-space data;
- construct trial k-space data by adding Gaussian noise to the resampled k-space data, wherein the trial image is constructed by applying the inverse of the non-equispaced FFT to the trial k-space data.

11. The medical system of claim 9, wherein the ground truth image is the training image and/or wherein the training image is constructed by adding noise with the training noise profile to the training image.

12. The medical system of any one of claim 9, 10, or 11, wherein the selected noise filtering neural network is trained in residual learning mode.

13. A method of training a group of noise filtering neural networks (122), wherein the method comprises:
- receiving (500) a training k-space sampling pattern;
- receiving (502) a training magnetic resonance imaging reconstruction algorithm;
- determine (504) a training noise profile using the k-space sampling pattern and the training magnetic resonance imaging reconstruction algorithm;
- receiving (506) a group of training images;
wherein execution of the machine executable instructions further causes the computational system to repeatedly:
- selecting (510) a training image (700) from the group of training images;
- constructing (512) a ground truth image (706, 716) from the training image;
- constructing (514) a trial image (704) with the training noise profile from the training image;
- training (516) a selected noise filtering neural network using the trial image and the ground truth image, wherein the selected noise filtering neural network is a member of the group of noise filtering neural networks, wherein the selected noise filter neural network has the specified noise profile set to the training noise profile; and
- adding (518) the selected noise filtering neural network to the group of noise filtering neural networks.

14. A computer program comprising machine executable instructions (120) for execution by a computational system (104), wherein the computer program further comprises a group of noise filtering neural networks (122), wherein each of the group of noise filtering neural networks is configured to output a noise filtered magnetic resonance image (132, 604) in response to receiving an input magnetic resonance image (124, 600), wherein each of the group of noise filtering neural networks is configured to remove noise of a specified noise profile from the input magnetic resonance image, wherein the execution of the machine executable instructions causes the computational system to:
- receive (200) the input magnetic resonance image;
- receive (202) image metadata (126) comprising an image noise profile (128) of the input magnetic resonance image;
- select (204) a chosen noise filtering neural network (130) by matching the image noise profile to the specified noise profile of each of the group of noise filtering neural networks using a predetermined criterion; and
- receive (206) the noise filtered magnetic resonance image in response to inputting the input magnetic resonance image into the chosen noise filtering neural network.

15. A method of medical imaging, wherein the method comprises:
- receiving (200) an input magnetic resonance image 8124, 600);
- receiving (202) image metadata (126) comprising an image noise profile of the input magnetic resonance image;
- selecting (204) a chosen noise filtering neural network (130) by matching the image noise profile to the specified noise profile of each of a group of noise filtering neural networks using a predetermined criterion, wherein each of the group of noise filtering neural networks is configured to output a noise filtered magnetic resonance image (132, 604) in response to receiving the input magnetic resonance image, wherein each of the group of noise filtering neural networks is configured to remove noise of a specified noise profile from the input magnetic resonance image; and
- receiving (206) the noise filtered magnetic resonance image in response to inputting the input magnetic resonance image into the chosen noise filtering neural network.
